Europäisches Patentamt

European Patent Office

Office européen des brevets

(19)

(11) Numéro de publication : **0 112 760**
**B1**

(12) **FASCICULE DE BREVET EUROPÉEN**

(45) Date de publication du fascicule du brevet :
07.05.86

(51) Int. Cl.⁴ : **H 01 L 23/48, H 01 L 23/04**

(21) Numéro de dépôt : **83402383.0**

(22) Date de dépôt : **09.12.83**

(54) Microboîtier d'encapsulation d'un composant électronique, muni d'une pluralité de connexions repliées.

(30) Priorité : **17.12.82 FR 8221229**

(43) Date de publication de la demande :
**04.07.84 Bulletin 84/27**

(45) Mention de la délivrance du brevet :
**07.05.86 Bulletin 86/19**

(84) Etats contractants désignés :
**DE GB NL**

(56) Documents cités :
PATENTS ABSTRACTS OF JAPAN, vol. 5, no. 117, (E-67) (789), 28 juillet 1981
IBM TECHNICAL DISCLOSURE BULLETIN, vol. 25, no. 4, septembre 1982, New York (US) E. BARKHUFF et al.: "Attachment method for chip carriers", pages 1934-1935

(73) Titulaire : **THOMSON-CSF**
**173, Boulevard Haussmann**
**F-75379 Paris Cedex 08 (FR)**

(72) Inventeur : **Lacruche, Bernard**
**THOMSON-CSF SCPI 173, bld Haussmann**
**F-75379 Paris Cedex 08 (FR)**

(74) Mandataire : **Taboureau, James et al**
**THOMSON-CSF SCPI 19, avenue de Messine**
**F-75008 Paris (FR)**

## Description

La présente invention concerne un microboîtier pour composants électroniques comportant une pluralité de connexions d'accès à braser, repliées sous le boîtier et constitué d'un matériau non mouillable par un métal de brasure en fusion.

Les boîtiers concernés par l'invention sont tous les boîtiers plats dont les connexions d'accès sont elles-mêmes repliées sous le boîtier ; les connexions peuvent être découpées dans une feuille de métal pour former une grille, comme c'est le cas pour beaucoup de circuits intégrés encapsulés dans des boîtiers plastiques ou céramiques, mais elles peuvent également être déposées par sérigraphie ou par métallisation sous vide ou électrolytique, comme c'est le cas pour les microboîtiers céramiques connus sous le nom de « chip carrier ». Deux caractéristiques communes des boîtiers concernés par l'invention sont d'avoir un corps non mouillable par la brasure tendre — les boîtiers métalliques étant de ce fait exclus du domaine de l'invention — et de n'être pas enfichables dans des trous pratiqués dans le substrat du circuit électrique, comme le seraient les composants discrets du type transistor ou les circuits intégrés en boîtier DIL par exemple.

Le fait de ne pas être enfichable pose des problèmes pour la fixation de ces boîtiers : il faut les immobiliser en place par collage du corps sur le substrat, puis braser les connexions par fusion d'une couche de brasure préalablement déposée sur les pistes conductrices du circuit électrique du substrat. Or, il y a opposition entre le fait que le microboîtier est immobilisé par collage et le fait que, lorsque la brasure fond, le microboîtier doit se déplacer pour que ses connexions viennent en contact direct avec les pistes du substrat. De plus, les dépôts de brasure ne sont pas toujours parfaitement positionnés et d'épaisseur constante : il en résulte des courts-circuits entre deux connexions voisines, ou un manque de contact entre une connexion et un dépôt de brasure trop faible, encadré par deux dépôts de brasure plus épais.

Ces inconvénients sont évités par le boîtier selon l'invention qui comporte, sous le corps de boîtier et en contact avec les parties repliées des connexions, une rainure dans laquelle est placé un fil de brasure, ou une pâte à braser. Le microboîtier ainsi préparé est collé sur le substrat, puis la fusion de la brasure est effectuée par des moyens classiques pour apporter la quantité de chaleur nécessaire : passage au four, brasage en phase vapeur, chalumeau à air chaud... etc. Le métal de brasure fond et, par capillarité, se déplace le long des connexions jusqu'à venir au point de contact entre une connexion et la piste métallique correspondante, point en lequel il est piégé puisque les forces de capillarité y sont maximales. Après refroidissement, le microboîtier est brasé sur le circuit, et le cordon de brasure qui se trouvait dans la rainure a été sectionné en autant de points de brasure qu'il existe de connexions externes sur le boîtier.

De façon plus précise l'invention concerne un microboîtier d'encapsulation d'un composant électronique, muni d'une pluralité de connexions d'accès extérieures repliées sous le corps de boîtier, celui-ci étant en un matériau non mouillable par un métal de brasure en fusion, ce microboîtier étant caractérisé en ce que, en vue de braser les connexions extérieures sur les pistes métalliques d'un circuit d'interconnexion, le métal d'apport de brasure est intégré au microboîtier, dans au moins une rainure pratiquée dans la face inférieure du microboîtier, à proximité de l'extrémité des connexions extérieures, de façon que le métal d'apport de brasure soit au contact desdites extrémités.

L'invention sera mieux comprise par la description d'un exemple de réalisation, laquelle s'appuie sur les figures jointes en annexe et qui représentent :
figure 1 un modèle de microboîtier à connexions repliées, selon l'art connu,
figure 2 vue en coupe d'un microboîtier plastique selon l'art connu, mettant en évidence le problème du brasage des connexions,
figure 3 vue en coupe d'un microboîtier céramique selon l'art connu,
figure 4 vue en coupe d'un microboîtier plastique selon l'invention, mettant en évidence, sur la partie gauche de la figure, sa structure avant brasure et sur la partie droite la brasure obtenue,
figure 5 vue en plan d'un microboîtier selon l'invention, vue de dessous.

Les objets concernés par le type de microboîtier selon l'invention sont très nombreux et ce peuvent être aussi bien des pastilles de circuits intégrés que des transistors ou d'autres composants encapsulés dans des boîtiers destinés à la réalisation de circuits complexes. Toutefois, et sans pour autant apporter une limitation au domaine de l'invention, celle-ci sera décrite en s'appuyant sur le cas le plus complexe de l'encapsulation d'un circuit intégré dans un microboîtier à connexions périmétriques. Il est bien entendu que les microboîtiers n'ayant de connexions que sur un ou deux côtés parallèles entre eux appartiennent également au domaine de l'invention, cependant la tendance actuelle à l'intégration à grande échelle amène à avoir un nombre toujours plus grand de connexions de sortie qui sont donc très proches les unes des autres et très difficiles à braser. C'est pourquoi il apparaît préférable d'exposer le cas d'un circuit intégré, dans un boîtier à quarante-quatre sorties par exemple plutôt que le cas d'un transistor encapsulé dans un microboîtier à trois sorties pour circuits hybrides.

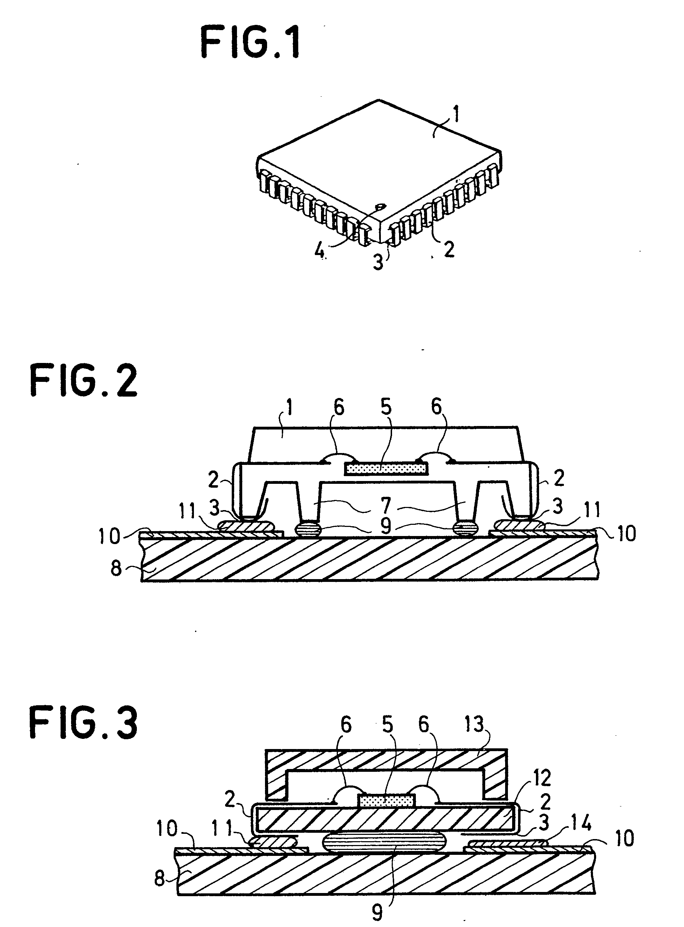

La figure 1 représente une vue de trois quarts dans l'espace d'un microboîtier à connexions repliées, selon l'art connu. Ce microboîtier, tel que représenté sur la figure 1, est un boîtier comportant un corps 1 protégeant la pastille du circuit intégré encapsulée à l'intérieur, et doté sur un ou plusieurs de ses côtés de connexions métalliques 2, qui sont repliées deux fois de façon à former, en 3, une semelle de prise de contact en dessous du boîtier. Les connexions telles qu'elles apparaissent sur cette figure sont obtenues par découpe chimique ou poinçonnage d'une feuille métallique de façon à former une grille sur laquelle est fixée la pastille de circuit intégré. Lorsque l'encapsulation de la pastille est achevée, les parties externes des connexions 2 sont repliées. Un indice de repère 4, ou un coin du boîtier, différent des autres, permet d'orienter le boîtier et constitue une base de repère pour l'identification des connexions externes.

Un autre type de boîtier, tout à fait comparable à ce boîtier plastique et à connexions en feuilles métalliques, est constitué par le boîtier céramique dont les connexions externes sont généralement sérigraphiées ou déposées par évaporation sous vide sur les flancs et sur la partie inférieure de ce boîtier : un tel boîtier est connu sous le nom de « chip carrier ».

Ces boîtiers, qu'ils soient plastiques ou céramiques, sont de plus en plus répandus en raison de la disproportion qui existe entre les dimensions d'une pastille de circuit intégré et les dimensions des boîtiers classiques à 40, 60 connexions externes et même plus. Le boîtier plastique à connexions périmétriques ou le « chip carrier » permet de gagner considérablement en densité pour un circuit électrique, mais, par contre, la brasure des connexions de sortie du boîtier sur un circuit supporté par un substrat devient de plus en plus délicate en raison des dimensions extrêmement petites des connexions et des intervalles entre deux connexions externes.

La figure 2 représente une vue en coupe du microboîtier plastique de la figure 1, et elle est destinée à mettre en évidence les difficultés de soudure de ces microboîtiers sur un substrat. L'échelle des hauteurs est dilatée sur cette figure de façon à la rendre plus facilement lisible.

Le corps 1 du microboîtier est représenté coupé en son milieu de façon à montrer la pastille 5 de circuit intégré, ou de façon plus générale du composant encapsulé, réuni par des fils d'or ou d'aluminium 6 aux connexions externes 2. Celles-ci qui sont périmétriques et sont repliées en 3 sous le boîtier, qui a une forme adaptée, afin d'éviter que les parties repliées 3 des connexions externes ne soient accrochées, par effleurement par exemple, et arrachées. Un tel boîtier comporte en général plusieurs plots de matière 7 qui permettent d'éviter un écrasement des connexions lorsque le boîtier est appliqué contre le circuit sur lequel il doit être soudé.

De son côté, le circuit électrique sur lequel doit être soudé le microboîtier est composé d'un substrat 8, qui selon les cas peut être de type verre époxy s'il s'agit d'un circuit imprimé ou de type céramique s'il s'agit d'un circuit hybride, ou encore d'un type plus récent en tôle émaillée. De toutes façons, le substrat 8 du circuit a au moins une surface isolante, sur laquelle est déposé et gravé le circuit électrique d'interconnexion dont deux pistes 10 sont représentées, aboutissant sous les connexions extérieures du microboîtier.

L'opération de brasage d'un tel microboîtier sur un circuit électrique supporté par un substrat 8, nécessite deux opérations. En premier lieu, il est nécessaire d'apporter du métal de brasure, soit sur les connexions extérieures, soit sur l'extrémité des pistes 10 en regard des connexions extérieures, cet apport de métal de brasure étant réalisé sous forme d'un dépôt 11 obtenu par différents procédés tels que l'étamage épais du substrat, le dépôt d'une pâte par sérigraphie, le passage à la vague du circuit de conducteurs 10.

Par ailleurs, le positionnement précis du microboîtier 1 par rapport au réseau de conducteurs 10, et en raison des dimensions extrêmement faibles — le pas des connexions externes étant de 1,27 mm — s'obtient par collage des plots 7 sur le substrat 8 par des gouttes de colle 9.

Il en résulte qu'il y a une ambiguïté entre le fait que le microboîtier 1 est immobilisé par les gouttes de colle 9, et le fait que les dépôts 11 de métal de brasure n'ont pas tous soit un positionnement précis, ce qui peut engendrer des courts-circuits entre deux connexions voisines, soit une épaisseur précise, ce qui peut engendrer qu'après brasure une ou plusieurs connexions, ne touchant pas le dépôt de métal de brasure 11, ne sont pas en contact avec la piste métallique 10 qui leur correspond.

La figure 3 représente une vue en coupe d'un autre type de microboîtier à connexions périmétriques dont les connexions sont repliées sous le boîtier.

Les différences entre un tel microboîtier céramique et le boîtier de la figure précédente sont assez minimes : le corps du boîtier céramique est constitué d'une embase 12 et d'un couvercle 13 formant une cavité à l'intérieur de laquelle est encapsulé le composant 5, réuni par des fils d'or 6 aux connexions externes 2. Celles-ci ne sont plus des bandes métalliques découpées et repliées sous le boîtier, mais sont obtenues directement par métallisation par sérigraphie ou dépôt sous vide des faces supérieure et inférieure de l'embase 12, avec continuité sur ses flancs. Que les connexions externes 2 soient obtenues directement ou par gravure d'une métallisation générale ne change rien au fait que les dites connexions ne peuvent pas être enfichées dans des trous pratiqués dans le substrat 8. Par conséquent, ce microboîtier est un objet qu'il convient de fixer dans sa bonne position par l'intermédiaire d'une goutte de colle 9 avant de procéder à la brasure de ses connexions externes. L'opération est la même que pour le microboîtier plastique de la figure 2, mais du fait qu'on ne peut même plus compter sur la souplesse des connexions en ruban métallique, puisque dans le cas présent ce sont des dépôts en surface d'une céramique, les risques de mauvaises brasures sont augmentés et la partie gauche de la figure représente une connexion correctement brasée par l'intermédiaire du dépôt de brasure 11, tandis que la partie droite représente le résultat obtenu avec un dépôt 14 qui était à l'origine plus faible que les dépôts voisins : le contact n'étant pas établi entre la connexion 2 et le dépôt 14, celui-ci a fondu, s'est étalé en mouillant la piste 10 et il n'y a pas de contact sur cette connexion externe.

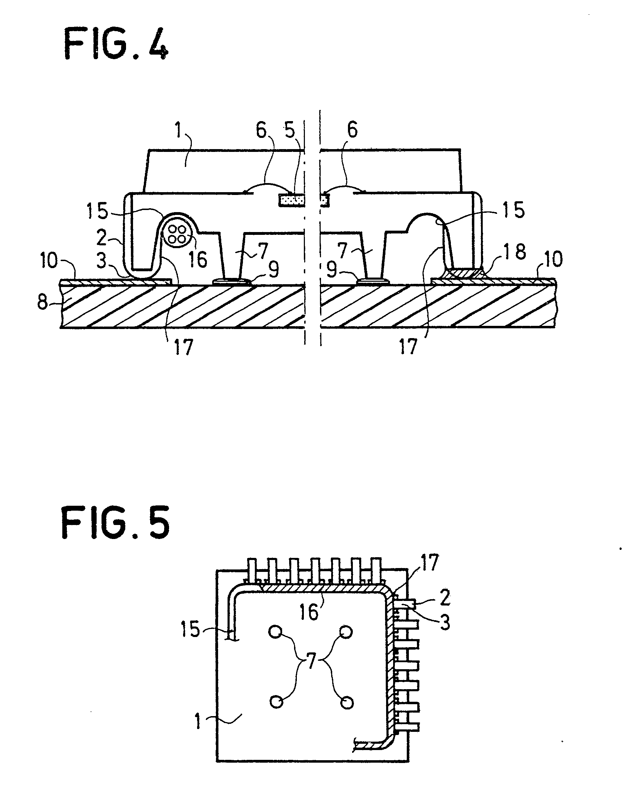

La figure 4 représente une vue en coupe d'un microboîtier selon l'invention, cette vue étant constituée d'une partie gauche qui représente le microboîtier avant l'opération de brasure et d'une partie droite qui représente le microboîtier brasé en place.

La représentation adoptée pour cette figure est celle d'un microboîtier plastique, mais la configuration d'un microboîtier céramique appartient également au domaine de l'invention, la seule différence étant une question de géométrie du recourbement en 3 des connexions extérieures 2.

Selon l'invention, le corps 1 du microboîtier est doté sur sa partie inférieure, c'est-à-dire sur sa face en regard avec le circuit électrique d'interconnexion sur lequel il doit être brasé d'une rainure 15. Cette rainure est pratiquée dans l'épaisseur du matériau du microboîtier, de telle façon qu'elle soit à proximité immédiate de la partie extrême repliée sous le boîtier des connexions 2. Selon la forme du boîtier et selon la disposition des connexions externes, la rainure 15 peut être constituée d'une boucle périphérique ou d'une pluralité d'éléments de rainures s'il n'y a de connexions externes que sur certains côtés par exemple. Dans cette rainure 15 est disposé un métal de brasure 16, apporté soit sous la forme d'un fil de brasure telle qu'elle est disponible dans le commerce, soit sous la forme du remplissage de la rainure 15 par une pâte du genre des pâtes à sérigraphier. Il est important que le métal de brasure 16, quelle que soit la forme sous laquelle il est apporté, soit en contact avec l'extrémité 17 de la partie repliée sous le boîtier des connexions externes 2. En effet, lorsque l'opération de brasure amènera le métal de brasure 16 à son point de fusion, il est nécessaire que le métal de brasure soit en contact avec le métal de la connexion externe, en 17, de façon à migrer par capillarité jusqu'au point de contact entre la partie repliée 3 de la connexion externe et la piste 10 du circuit électrique. La partie gauche de la figure 4 représente le cordon de brasure 16 en position avant l'opération de brasure, ce cordon remplissant la cavité 15, tandis que la partie droite représente la brasure, en 18, de la connexion externe du microboîtier, la rainure 15 étant vidée de son contenu de métal d'apport.

Au cours de la fusion du cordon de brasure 16, le métal — ou plus précisément l'alliage — se fragmente en gouttelettes, formées autour des extrémités 17 des connexions extérieures 2, parce que celles-ci sont métalliques, donc mouillables. Par contre, le corps du boîtier n'étant pas mouillable, il ne reste pas de métal de brasure, donc pas de court-circuit, entre les connexions extérieures 2.

Le fondement même de l'invention suppose donc que le corps, ou tout au moins la surface inférieure du microboîtier ne soit pas mouillable par un métal de brasure en fusion : c'est pourquoi l'invention est essentiellement applicable aux microboîtiers plastiques et céramiques qui sont d'ailleurs pratiquement les seuls utilisés lorsqu'il s'agit d'obtenir un très grand nombre de connexions externes dans un encombrement réduit.

La figure 4 met encore en évidence que le microboîtier peut être positionné par rapport au circuit électrique, et donc par rapport au substrat 8 et aux pistes 10, par collage en 9 : les connexions externes 2 sont en contact direct par leur partie recourbée 3 avec les pistes métalliques 10. Il n'y a donc plus d'ambiguïté entre le fait que le microboîtier est immobilisé par des points de colle 9, et le fait, comme c'était le cas en figure 2, que ce microboîtier doit se déplacer au cours de l'opération de brasure pour que ses connexions externes viennent en contact avec les pistes : ce résultat est acquis avant l'opération de brasure : ce n'est plus le microboîtier qui se déplace mais le métal de brasure.

La figure 5 représente une vue en plan partielle d'un microboîtier selon l'invention, vu de dessous. Cette figure met en évidence que pour un microboîtier à connexions périmétriques, tel que celui qui a servi de base à l'exposé de l'invention, une rainure 15 est pratiquée en dessous du boîtier, de telle façon que le métal 16 qui remplit cette rainure soit en contact direct avec l'extrémité interne 17 de chaque connexion 2.

L'invention a entre autres avantages celui de permettre le choix du meilleur métal d'apport de brasure selon les conditions, soit selon la nature des métaux à braser, soit selon la nature des moyens disponibles pour la brasure et des températures de four à air ou en phase vapeur. Ce choix peut être obtenu en choisissant un fil de brasure 16 parmi une gamme d'alliages différents, ou une pâte à sérigraphier convenablement élaborée. En outre, le procédé selon l'invention permet de doser la quantité de brasure, en pratiquant une gorge 15 et une quantité de métal d'apport 16 adapté au nombre et aux dimensions de brasures à effectuer, il n'y a donc plus d'irrégularités comme cela a été le cas avec les microboîtiers selon l'art connu. Enfin, puisque le métal de brasure se déplace par capillarité, les problèmes de positionnement précis d'un métal d'apport 11 déposé par sérigraphie, par exemple, sont éliminés. La géométrie du point de brasure obtenue avec le microboîtier selon l'invention est constante, reproductible et il n'y a pas de court-circuit entre deux connexions externes voisines.

Enfin, dans certains cas tels que celui des circuits intégrés MOS qui sont particulièrement fragiles à l'électricité statique, le cordon de métal d'apport de brasure 16 qui réunit et court-circuite toutes les connexions externes du microboîtier, avant que celui-ci né soit définitivement mis en place et brasé, constitue la meilleure des protections contre des décharges externes accidentelles d'électricité statique, puisque en effet, toutes les connexions d'accès à la pastille de MOS sont court-circuitées entre elles.

Bien entendu, si l'invention a été exposée en s'appuyant sur le cas bien précis de pastilles de circuits intégrés et de boîtiers à connexions périmétriques, il n'en reste pas moins qu'elle est applicable à d'autres types de microboîtiers, quelque soit d'ailleurs le composant encapsulé dans de tels microboîtiers, et qui ne comportent pas obligatoirement autant de connexions externes que dans le cas de circuits intégrés à grande échelle. Le fondement de l'invention étant basé sur le positionnement précis, obtenu par capillarité, d'une quantité contrôlée de métal de brasure qui se déplace, le boîtier ne se déplaçant pas. Cette invention est précisée par les revendications suivantes.

**Revendications**

1. Microboîtier d'encapsulation d'un composant électronique, muni d'une pluralité de connexions d'accès extérieures (2) repliées (en 3) sous le corps de boîtier (1), celui-ci étant en un matériau non mouillable par un métal de brasure en fusion, ce microboîtier étant caractérisé en ce que, en vue de braser les connexions extérieures (2) sur les pistes métalliques (10) d'un circuit d'interconnexion, le métal d'apport de brasure (16) est intégré au microboîtier, dans au moins une rainure (15) pratiquée dans la face inférieure du microboîtier, à proximité de l'extrémité (17) des connexions extérieures (2), de façon que le métal d'apport de brasure (16) soit au contact desdites extrémités (17).

2. Microboîtier d'encapsulation selon la revendication 1, caractérisé en ce que les extrémités (17) des connexions extérieures (2) et le métal d'apport de brasure (16) sont disposés de façon telle que, à la température de brasage, du métal d'apport de brasure (16) se déplace par capillarité à partir de l'extrémité (17) de la connexion extérieure (2) jusqu'au point de contact entre la partie repliée (3) de connexion et la piste (10) du circuit.

3. Microboîtier d'encapsulation selon la revendication 1, caractérisé en ce que le métal d'apport de brasure (16) est constitué par un fil de métal introduit dans la rainure (15).

4. Microboîtier d'encapsulation selon la revendication 1, caractérisé en ce que le métal d'apport de brasure (16) est constitué par une pâte à braser dont est remplie la rainure (15).

5. Microboîtier d'encapsulation selon la revendication 1, caractérisé en ce que le métal d'apport de brasure (16) constitue, avant les opérations de brasure du boîtier sur un circuit d'interconnexion, un court-circuit de protection du dispositif encapsulé dans ledit microboîtier.

**Claims**

1. A micro-housing for encapsulating an electronic component having a plurality of connections (2) to the outside which are bent back (at 3) under the housing (1), the housing being made of a material which cannot be wetted by a molten soldering metal, characterized in that the soldering metal (16) intended to solder the outside connections (2) onto the metal strips (10) of an interconnection circuit is integrated to the micro-housing in at least one groove (15) provided in the lower surface of the micro-housing close to the end (17) of the outside connections (2) in such a way that the soldering metal (16) is in contact with these ends (17).

2. A micro-housing for encapsulation according to claim 1, characterized in that the ends (17) of the outside connections (2) and the soldering metal (16) are disposed in such a way that soldering metal (16) migrates by capillarity at the soldering temperature from the end (17) of the outer connection (2) to the point of contact between the bent portion (3) of the connection and the strip (10) of the circuit.

3. A micro-housing for encapsulation according to claim 1, characterized in that the soldering metal (16) is constituted by a metal wire inserted into the groove (15).

4. A micro-housing for encapsulation according to claim 1, characterized in that the soldering metal (16) is constituted by a soldering paste filling the groove (15).

5. A micro-housing for encapsulation according to claim 1, characterized in that prior to the operations of soldering the housing onto the interconnection circuit, the soldering metal (16) constitutes a short-circuit which is intended to protect the device encapsulated in said micro-housing.

**Patentansprüche**

1. Mikrogehäuse für die Einkapselung eines elektronischen Bauelements, das eine Vielzahl von unter das Gehäuse (bei 3) umgebogenen Außenanschlüssen (2) aufweist, wobei das Gehäuse (1) aus einem durch ein geschmolzenes Lötmetall nicht benetzbaren Material besteht, dadurch gekennzeichnet, daß zum Auflöten der Außenanschlüsse (2) auf die Metallstreifen (10) eines Verbindungsschaltkreises das Lötmetall (16) in das Mikrogehäuse integriert ist, und zwar in mindestens einer Rille (15), die in die Unterseite des Mikrogehäuses in der Nähe der Enden (17) der Außenanschlüsse (2) derart eingebracht ist, daß das Lötmetall (16) mit diesen Enden (17) in Kontakt steht.

2. Mikrogehäuse für die Einkapselung nach Anspruch 1, dadurch gekennzeichnet, daß die Enden (17) der Außenanschlüsse (2) und das Lötmetall (16) so angeordnet sind, daß bei der Löttemperatur Lötmetall (16) von den Enden (17) des Außenanschlusses (2) bis zum Berührungspunkt zwischen den umgebogenen Bereichen (3) der Verbindung und dem Metallstreifen (10) des Schaltkreises durch Kapillarkräfte befördert wird.

3. Mikrogehäuse zur Einkapselung nach Anspruch 1, dadurch gekennzeichnet, daß das Lötmetall (16) aus einem Metalldraht besteht, der in die Rille (15) eingebracht ist.

4. Mikrogehäuse zur Einkapselung nach Anspruch 1, dadurch gekennzeichnet, daß das Lötmetall (16) aus einer Lötpaste besteht, mit der die Rille (15) gefüllt ist.

5. Mikrogehäuse zur Einkapselung nach Anspruch 1, dadurch gekennzeichnet, daß das Lötmetall (16) vor dem Verlöten des Gehäuses mit einem Verbindungsschaltkreis einen Kurzschluß zum Schutz der im Mikrogehäuse eingekapselten Vorrichtung bildet.

# FIG.1

# FIG.2

# FIG.3

# FIG. 4

# FIG. 5